(19)

**Europäisches Patentamt**
**European Patent Office**
**Office européen des brevets**

(11) **EP 4 624 984 A1**

(12) **EUROPEAN PATENT APPLICATION**

(43) Date of publication:
**01.10.2025 Bulletin 2025/40**

(21) Application number: **25164643.6**

(22) Date of filing: **19.03.2025**

(51) International Patent Classification (IPC):
**G01S 7/481** (2006.01)     **G01S 7/4911** (2020.01)
**G01S 7/4914** (2020.01)     **G01S 7/4912** (2020.01)
**G01S 17/34** (2020.01)

(52) Cooperative Patent Classification (CPC):
**G01S 7/4815; G01S 7/4816; G01S 7/4818;**
**G01S 7/4911; G01S 7/4914; G01S 7/4917;**
**G01S 17/34**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **27.03.2024 KR 20240042008**

(71) Applicant: **Samsung Electronics Co., Ltd.**
**Suwon-si, Gyeonggi-do 16677 (KR)**

(72) Inventors:
• **PARK, Sangyun**
**16678 Suwon-si (KR)**
• **HWANG, Inoh**
**16678 Suwon-si (KR)**
• **BYUN, Hyunil**
**16678 Suwon-si (KR)**

• **CHOI, Jinwoo**
**16678 Suwon-si (KR)**
• **KO, Byunghoon**
**16678 Suwon-si (KR)**
• **KIM, Sunil**
**16678 Suwon-si (KR)**
• **NOH, Seungwoo**
**16678 Suwon-si (KR)**
• **LEE, Minkyung**
**16678 Suwon-si (KR)**
• **LEE, Jisan**
**16678 Suwon-si (KR)**
• **JEONG, Byunggil**
**16678 Suwon-si (KR)**

(74) Representative: **Elkington and Fife LLP**
**Prospect House**
**8 Pembroke Road**
**Sevenoaks, Kent TN13 1XR (GB)**

(54) **LIDAR SYSTEM USING MULTIPLE WAVELENGTHS AND OPERATING METHOD THEREOF**

(57) A **LiDAR** system includes a signal generator configured to generate a plurality of multiplexed lights, a transceiver including a transmitter and a receiver, wherein the transceiver is configured to simultaneously emit the plurality of multiplexed lights as a transmission signal in units of pixel groups including at least two pixels, and the receiver is configured to mix the transmission signal and a received signal that is incident when the transmission signal is reflected from a target object and convert the mixed signal into an electrical signal; and a electric circuit connected to the signal generator and the transceiver, and configured to control operation thereof.

FIG. 1

EP 4 624 984 A1

**Description**

FIELD OF THE INVENTION

The disclosure relates to a light detection and ranging (LiDAR) system and a method of operating the same.

BACKGROUND OF THE INVENTION

LiDAR technology for distance measurement has evolved, using solid-state sensors. Frequency modulated continuous wave (FMCW) LiDAR is notable for its capability to detect target objects using signals represented by a triangular wave in the frequency domain over time.

In FMCW mode, implementing x-y plane scanning in solid-state LiDAR systems may involve using focal plane arrays (FPAs). In conventional LiDAR setups, FPAs may constrain resolution due to the limited number of arrays on the focal plane. As the distance to a target object increases, attempting to enhance resolution by increasing the number of arrays in FPAs may yield diminishing returns. This limitation may affect critical applications such as safe autonomous driving, where maintaining high frame rates and resolution is important.

SUMMARY OF THE INVENTION

One or more embodiments of the present application provide an FPA-based LiDAR system that offers high-resolution scanning, even at increased target distances, by introducing wavelength division multiplexing (WDM) into the FPA method.

According to an aspect of the present disclosure, a light detection and ranging (LiDAR) system may include: a signal generator configured to generate a plurality of multiplexed lights; a transceiver comprising a transmitter and a receiver, wherein the transceiver is configured to simultaneously emit the plurality of multiplexed lights as a transmission signal, and the receiver is configured to mix the transmission signal and a received signal that is incident when the transmission signal is reflected from a target object to obtain a mixed signal and convert the mixed signal into an electrical signal; and an electric circuit connected to the signal generator and the transceiver, and configured to control the signal generator and the transceiver.

According to another aspect of the present disclosure, an operating method of a light detection and ranging (LiDAR) system may include: generating a plurality of multiplexed lights; simultaneously emitting the plurality of multiplexed lights as a transmission signal; mixing a transmission signal and a received signal that is incident when the transmission signal is reflected from a target object to obtain a mixed signal; and converting the mixed signal into an electrical signal.

According to another aspect of the present disclosure, a vehicle may include: a signal generator comprising at least one light source configured to generate a plurality of emitting lights of different wavelengths; a transceiver configured to: emit the plurality of emitting lights at a plurality of different angles; and detect a plurality of reflected lights through one of a plurality of pixels included in a focal plan array, based on the plurality of reflected lights being received when the plurality of emitting lights are reflected from a plurality of spatial points on a target object; and a processor configured to determine a distance to the target object based on the plurality of reflected lights, and control a driving status of the vehicle based on the distance to the target object.

The plurality of pixels in the focal plan array are arranged in a plurality of rows and a plurality of columns, each of the plurality of rows may include a switch to selectively provide the plurality of reflected lights, and each of the plurality of pixels in a same row may include another switch to selectively provide the plurality of reflected lights.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 illustrates a graph (a) showing a transmission signal transmitted from FMCW LiDAR and a received signal generated when the transmission signal is reflected from a target object, and a graph (b) showing a beat frequency;

FIG. 2 is a conceptual diagram for explaining a LiDAR system according to one or more embodiments;

FIG. 3A is a block diagram for explaining a light source unit that can be applied to a signal generator according to one or more embodiments;

FIG. 3B is a block diagram for explaining a light source unit that may be applied to a signal generator according to another embodiment;

FIG. 3C is a block diagram for explaining a light source unit that may be applied to a signal generator according to another embodiment;

FIG. 3D is a block diagram for explaining a light source unit that may be applied to a signal generator according to another embodiment;

FIG. 4 is a diagram for explaining pixels included in a focal plane array;

FIG. 5 is a block diagram for explaining a electric circuit according to one or more embodiments;

FIG. 6 is a diagram for explaining a driving method of a LiDAR system according to one or more embodiments;

FIG. 7A is a diagram for explaining a MEMS operation;

FIG. 7B is a diagram for explaining operation of a micro-ring resonator;

FIG. 8 is a diagram for explaining a driving method of a LiDAR system according to another embodiment;

FIG. 9 is a flowchart for explaining an operation method of a LiDAR system according to one or more embodiments;

FIG. 10 is a perspective view showing an example electronic device to which a LiDAR system according to one or more embodiments is applied; and

FIGS. 11 and 12 are conceptual diagrams showing a case when a LiDAR system according to one or more embodiments is applied to a vehicle, and are a side view and a top view, respectively.

## DETAILED DESCRIPTION

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Terminologies used herein are selected as commonly used by those of ordinary skill in the art in consideration of functions of the current embodiment, but may vary according to the technical intention, precedents, or a disclosure of a new technology. Also, in particular cases, some terms are arbitrarily selected by the applicant, and in this case, the meanings of the terms will be described in detail at corresponding parts of the specification. Accordingly, the terms used in the specification should be defined not by simply the names of the terms but based on the meaning and contents of the whole specification.

In the descriptions of the embodiments, it will be understood that, when an element is referred to as being connected to another element, it may include electrically connected when the element is directly connected to the other element and when the element is already given indirectly connected to the other element by intervening a constituent element. Additionally, it should be understood that, when a part "comprises" or "includes" an element in the specification, unless otherwise defined, it is not excluding other elements but may further include other elements.

It will be further understood that the term "comprises" or "includes" should not be construed as necessarily including various constituent elements and various operations described in the specification, and also should not be construed that portions of the constituent elements or operations of the various constituent elements and various operations may not be included or additional constituent elements and operations may further be included.

The descriptions of the embodiments should not be interpreted as limiting the scope of right, and embodiments that are readily inferred from the detailed descriptions and embodiments by those of ordinary skill in the art will be construed as being included in the disclosure. Reference will now be made in detail to embodiments, examples of which are illustrated in the accompanying drawings.

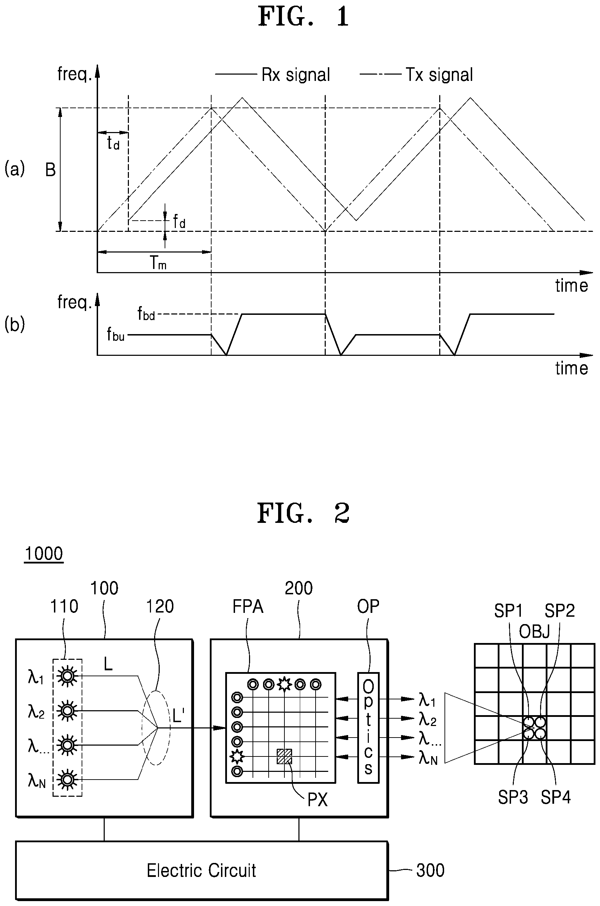

FIG. 1 illustrates graphs showing a transmission signal transmitted from FMCW LiDAR, a received signal generated when the transmission signal is reflected from a target object, and a beat frequency.

Graph (a) of FIG. 1 shows a transmission signal (Tx signal) transmitted from the FMCW LiDAR and a received signal (Rx signal) that is reflected and incident from a target object. There is a time delay td and a Doppler frequency difference fd between the transmission signal (Tx signal) and the received signal (Rx signal). Here, B refers to a modulation bandwidth and Tm refers to a modulation period.

Graph (b) of FIG. 1 shows a beat frequency expressed as a frequency difference between the transmission signal and the received signal. fbu refers to an up-bit frequency corresponding to an up chirp, and fbd refers to a down-bit frequency corresponding to a down chirp.

The up-beat frequency and down-beat frequency include frequency shift components due to a distance to a moving object and a relative speed. These are referred to as beat frequency (fb) and Doppler frequency (fd), respectively.

The up-beat frequency fbu and down-beat frequency fbd may be expressed by Equation 1 and Equation 2 below.

[Equation 1]

$$fbu = fb - fd$$

[Equation 2]

$$fbd = fb + fd$$

Here, a Doppler frequency having a positive value denotes that a moving object is approaching the LiDAR, and a Doppler frequency having a negative value denotes that the moving object is moving away from the LiDAR. Therefore, the distance between the moving object and the LIDAR may be obtained as an average of the up-beat frequency fbu and the down-beat frequency fbd, and a movement speed of the moving object may be calculated using the Doppler frequency fd. The up-beat frequency fbu and down-beat frequency fbd may be obtained by performing Fast Fourier Transform FFT on a received beat signal.

FIG. 2 is a conceptual diagram for explaining a light detection and ranging (LiDAR) system 1000 according to one or more embodiments.

Referring to FIG. 2, the LIDAR system 1000 may include a signal generator 100, a transceiver 200, and an electric circuit 300. The signal generator 100, the transceiver 200, and the electric circuit 300 may be configured on one chip (or semiconductor optical device).

According to one or more embodiments, the signal generator 100 may include a light source unit 110 and an optical coupler 120.

The light source unit 110 may generate a plurality of lights L having different wavelengths. The plurality of lights L may be referred to as electromagnetic waves of multi-wavelength (multi-$\lambda$). For example, the plurality of lights L may be a plurality of lasers having different wavelengths but may also be lights other than lasers. The light source unit 110 may generate a plurality of lights L simultaneously.

The optical coupler 120 may simultaneously receive a plurality of lights L generated from the light source unit 110 and output multiplexed lights L'.

Although not shown in the drawing, the light source unit 110 may further include an optical modulator for modulating a plurality of lights.

For frequency modulated continuous wave (FMCW) driving, the optical modulator (or signal generator 100) may perform frequency modulation (or chirping) as shown in FIG. 1 centered around the wavelength (e.g., $\lambda 1$, $\lambda 2$, to $\lambda N$). At this time, a bandwidth of frequency modulation (or chirping) determines depth resolution. For example, for 10cm depth resolution, frequency modulation (or chirping) is needed to occur with a bandwidth of approximately 1.5GHz. The implementation method of the frequency modulation (or chirping) may be either open-loop control or closed-loop control and may be pre-distorted based on information obtained through pre-calibration to improve linearity characteristics. A wider interval between the plurality of wavelengths $\lambda 1$, $\lambda 2$, to $\lambda N$ may be desirable than a bandwidth of frequency modulation for FMCW driving in terms of limiting crosstalk.

An optical modulator may modulate light in various ways. For example, an optical modulator may modulate a phase of light. Alternatively or additionally, the optical modulator may modulate an amplitude of light. Alternatively or additionally, the optical modulator may simultaneously modulate the phase and amplitude of light. The light modulation function of the light modulator may be changed in various ways. The optical modulator may perform optical modulation by electrical methods, or by various methods, such as a magnetic method, a thermal method, and a mechanical method. As a specific example, the optical modulator may include at least one phase shifter or phase shifting element, wherein the phase shifter may include, for example, at least one element selected from the group consisting of a gain element, an all-pass filter, a Bragg grating, a dispersive material element, a wavelength tuning element, a phase tuning element, etc. In addition, an actuation mechanism applied to the optical modulator may include at least one selected from the group consisting of, for example, thermo-optic actuation, electro-optic actuation, electroabsorption actuation, free carrier absorption actuation, magneto-optic actuation, liquid crystal actuation, all-optical actuation, etc. The actuation mechanism may be related to the phase tuning described above. However, the configuration and actuation mechanism of the phase shifter specifically described here are illustrative, and the embodiments are not limited thereto.

The LiDAR system 1000 may use two or more different wavelengths (e.g., $\lambda_1$, $\lambda_2$, $\lambda_3$, and $\lambda_4$) of light sources to enhance spatial resolution. Light emitted from each pixel has different emission angles depending on the wavelength, thereby improving spatial resolution. The LiDAR system 1000 may measure more spatial points than the number of pixels by simultaneously or sequentially driving multiple wavelengths at one pixel (e.g., a single pixel labeled as PX in FIG. 2). The LiDAR system 1000 may obtain information on two or more spatial points (e.g., SP1, SP2, SP3, and SP4 shown in FIG. 2) simultaneously by simultaneously or sequentially driving multiple wavelengths at one pixel.

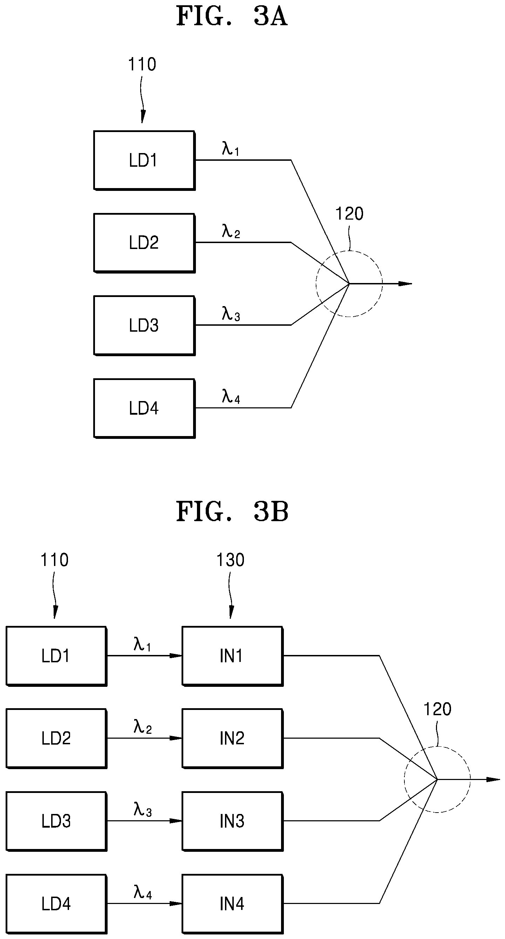

The specific configuration of the light source unit 110 will be described in detail later with reference to FIGS. 3A to 3D.

According to one or more embodiments, the transceiver 200 may include an optical element OP for controlling a focal plane array FPA in which a plurality of pixels PX (or pixel groups) are arranged in a matrix form and an output angle. The plurality of pixels may operate independently from each other, and different driving signals can be applied to the plurality of pixels, respectively.

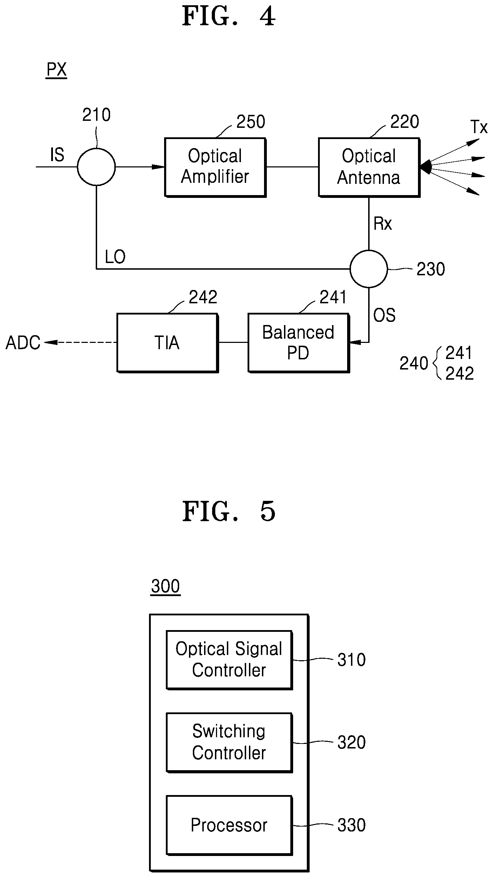

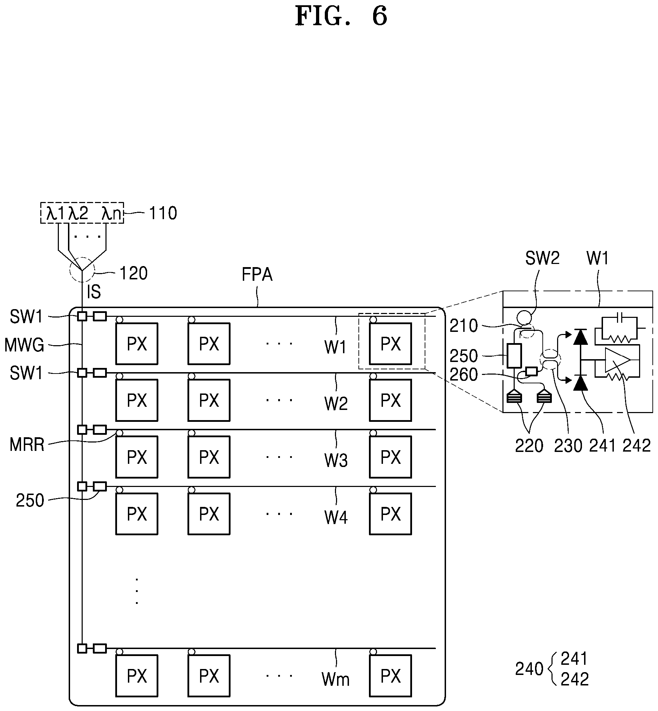

The transceiver 200 may be functionally divided into a transmitter and a receiver. The transmitter may correspond to an optical antenna 220 and an optical amplifier 250 of FIG. 4, which will be described later, and a first optical switch SW1 and a second optical switch SW2 of FIG. 6, which will be described later, and the receiver may correspond to a second optical coupler 230, a balanced photodiode (OD) 241, and a transimpedance amplifier (TIA) 242 of FIG. 4, which will be described later.

The transmitter may have a focal plane array FPA type in at least one of x-y axes. Additionally, the transmitter may emit a plurality of multiplexed lights L' simultaneously or sequentially as a transmission signal from one pixel PX included in the focal plane array FPA.

According to one or more embodiments, if the optical element OP emits a plurality of multiplexed lights L' from a pixel PX into free space, the optical element OP may be controlled to have different light exit angles depending on the wavelength. For example, the optical element OP may include a prism, a micro-prism array, a diffraction grating, etc.

The receiver may mix the transmission signal and the received signal that is incident when the transmission signal is reflected from a target object and convert the mixed signal into an electrical signal. For example, the receiver may be implemented with 50:50 coupling by using the second optical coupler 230 of FIG. 4, which will be described later, and then, the coupled light may be incident on the balanced photodiode 241. However, the coupling method is not limited thereto and may be implemented using, for example, a beam splitter. Regardless of the specific mixing implementation method, a signal obtained from the receiver may include tone frequency information for each wavelength of light. Light of each wavelength may include distance and/or speed information about the target object OBJ, the information is reflected in the tone frequency.

The electric circuit 300 is connected to the signal generator 100 and the transceiver 200 and may control operations thereof. For example, the electric circuit 300 may analyze a frequency of the electrical signal obtained from the transceiver 200 (or receiver) and convert it into distance and/or speed information of the target object OBJ. The specific configuration of the electric circuit 300 will be described in detail later with reference to FIG. 5.

Hereinafter, the configuration of the light source unit 110 will be described in more detail with reference to FIGS. 3A to 3D.

FIG. 3A is a block diagram for explaining the light source unit 110 that may be incorporated into the signal generator 100 according to one or more embodiments.

Referring to FIG. 3A, according to the embodiment, the light source unit 110 may include a plurality of laser sources LD1 to LD4. Here, four laser sources LD1 to LD4 are shown, but the number of laser sources may vary. The plurality of laser sources LD1 to LD4 may be, for example, laser diodes. A plurality of laser sources LD1 to LD4 may generate lasers of different wavelengths (e.g., $\lambda 1$, $\lambda 2$, $\lambda 3$, and $\lambda 4$). Lasers of different wavelengths $\lambda 1$, $\lambda 2$, $\lambda 3$, and $\lambda 4$ generated from the plurality of laser sources LD1 to LD4 may be input to the optical coupler 120 and multiplexed.

FIG. 3B is a block diagram for explaining a light source unit 110 that may be applied to a signal generator according to one or more embodiments.

Referring to FIG. 3B, lasers of different wavelengths (e.g., $\lambda 1$, $\lambda 2$, $\lambda 3$, and $\lambda 4$) generated from the plurality of laser sources LD1 to LD4 may be input into different input couplers IN1 to IN4. It may be seen that the plurality of input couplers IN1 to IN4 constitute one "input unit 130." The plurality of input couplers IN1 to IN4 may have, for example, an optical fiber structure or other configurations. A plurality of lights passing through the plurality of input couplers IN1 to IN4 may be multiplexed by the optical coupler 120.

In FIG. 3B, the plurality of input couplers IN1 to IN4 and the optical coupler 120 may be connected to a predetermined optical waveguide. In some cases, the plurality of input couplers IN1 to IN4 and the optical coupler 120 may be combined and regarded as one "input unit."

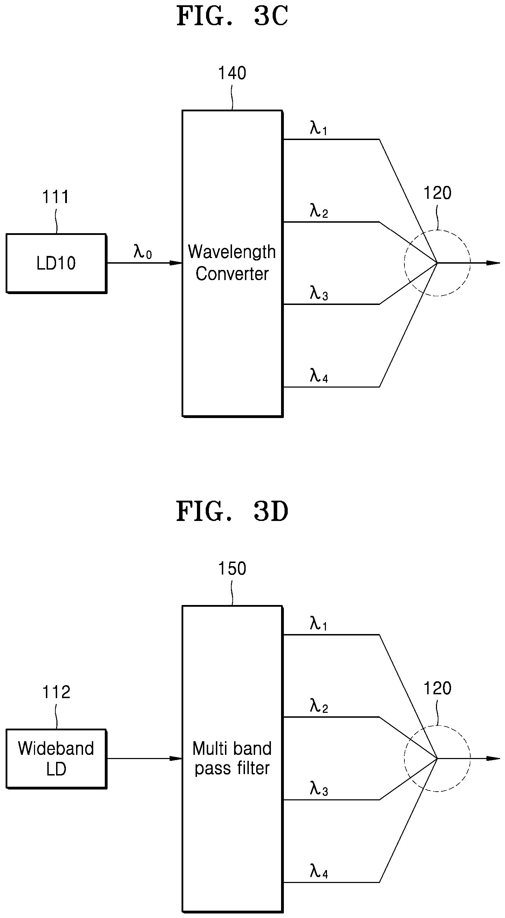

FIG. 3C is a block diagram for explaining a light source unit that may be incorporated to a signal generator according to one or more embodiments.

Referring to FIG. 3C, the light source unit 111 may include a laser source LD10 configured to generate a laser of a single wavelength $\lambda 0$. That is, the light source unit 111 may be configured of one laser source LD10. A wavelength converter 140 may further be provided to split a laser generated from the laser source LD10 into a plurality of lasers having different wavelengths (e.g., $\lambda 1$, $\lambda 2$, $\lambda 3$, and $\lambda 4$). For example, the wavelength converter 140 may include an input coupler, an optical splitter, and a plurality of wavelength conversion elements. A laser input to the input coupler may be split by the optical splitter and then a wavelength thereof may be converted by the plurality of wavelength conversion elements. As a result, a plurality of lights having different wavelengths (e.g., $\lambda 1$, $\lambda 2$, $\lambda 3$, and $\lambda 4$) may be output through the wavelength converter 140. The plurality of lights may be multiplexed by the optical coupler 120.

In FIG. 3C, the laser source LD10 and the wavelength converter 140 may be combined and considered as one "light source unit." The light source unit 111 may generate a plurality of lights having different wavelengths (e.g., $\lambda 1$, $\lambda 2$, $\lambda 3$, and $\lambda 4$). Also, at least a portion of the wavelength converter 140 or at least a portion of the optical coupler 120 may be considered an "input coupler." Alternatively, the wavelength converter 140 and the optical coupler 120 may be combined and considered as one input coupler.

FIG. 3D is a block diagram for explaining a light source unit 112 included in a signal generator according to one or more embodiments.

Referring to FIG. 3D, the light source unit 112 may include a wideband light emitter. In other words, the wideband light emitter may be a device that generates wideband light. The wideband light may cover from ultraviolet (UV) wavelengths (<400 nm) through visible light and into infrared (IR) ranges. A multi-band pass filter 150 may be provided to split light generated from the light source unit 112. Lights having a plurality of distinct wavelengths (e.g., $\lambda 1$, $\lambda 2$, $\lambda 3$, and $\lambda 4$) may be output through the multi-band pass filter 150. The plurality of lights may be multiplexed by the optical coupler 120.

In FIG. 3D, the wideband light emitter and the multi-band pass filter 150 may be combined and considered a single "light source unit." The light source unit 112 may generate a plurality of lights having different wavelengths. In the embodiment, the optical coupler 120 may be considered an "input coupler."

FIG. 4 is a diagram for explaining pixels included in the focal plane array FPA.

Referring to FIG. 4, the pixel PX may split an input signal IS into a local oscillator signal LO and a transmission signal Tx, emit the transmission signal Tx to a free space, couple the received signal Rx to the pixel PX, and mix the local oscillator signal LO with the received signal Rx.

The pixel PX according to one or more embodiments may include a first optical coupler 210, an optical antenna 220, a second optical coupler 230, and a photoelectric converter 240. The pixel PX may receive a plurality of multiplexed lights (see L' in FIG. 2) as an input signal IS. The first optical coupler 210 may be disposed between an input terminal INT and the optical antenna 220. The first optical coupler 210 may split the input signal IS received at the input terminal INT into a local oscillator signal LO and a transmission signal Tx. The optical antenna 220 may receive a received signal Rx reflected by the target object OBJ.

The optical antenna 220 may emit light from an on-chip waveguide into a free space and/or couples light from the free space into the on-chip waveguide. The optical antenna 220 may be implemented with a grating coupler, an edge coupler, an integrated reflector, or an arbitrary spot size converter. The optical antenna 220 may be sensitive to polarized light with much higher emission/coupling efficiency for light having one specific polarized light (e.g., transverse electric TE or transverse magnetic TM). The optical antenna 220 may be reciprocal and thus capable of collecting a received signal Rx from the target object OBJ to be measured (e.g., an object in an environment). The optical antenna 220 may provide a received signal Rx to the second optical coupler 230. FIG. 4 shows a co-axial implementation method in which light emission and collection are performed through the same optical antenna 220, but a bi-axial implementation method in which light emission and collection are performed separately using each optical antenna is also possible.

The second optical coupler 230 may generate an output signal OS by mixing the received signal Rx with the local oscillator signal LO divided by the first optical coupler 210. The second optical coupler 230 may be a balanced 2x2 optical mixer.

The pixel PX may include a photoelectric converter 240 that converts the output signal OS, which is an optical signal, into an electrical signal. The photoelectric converter 240 may include a balanced photodiode 241 configured to convert an optical signal into an electrical signal for detecting a tone frequency, and a transimpedance amplifier (TIA) 242 that amplifies the strength of the electrical signal generated by the balanced photodiode 241. For example, the TIA 242 may amplify a current generated by the balanced photodiode 241 and convert the current into a voltage. An electrical signal provided from the transimpedance amplifier TIA may be provided to an analog-to-digital converter ADC included in the electric circuit 300 in FIGS. 3 and 5.

The pixel PX according to one or more embodiments may further include an optical amplifier 250 that is disposed between the first optical coupler 210 and the optical antenna 220 and compensates for optical loss. For example, the optical amplifier 250 may be a semiconductor optical amplifier SOA and may amplify an optical signal so that the intensity of light generated by the light source unit (e.g., the light source unit 110 in FIG. 2) may be maintained in the optical antenna 220. Alternatively, the optical amplifier 250 may increase a signal-to-noise ratio (SNR).

FIG. 5 is a block diagram for explaining a electric circuit 300 according to one or more embodiments.

Referring to FIG. 5, the electric circuit 300 may include an optical signal controller 310, a switching controller 320, and a processor 330. The processor may execute instructions stored in memory to perform specific tasks or functions. In various embodiments, the processor may include, but is not limited to, a central processing unit (CPU), a microprocessor, a digital signal processor (DSP), a system-on-chip (SoC), or any other suitable integrated circuit or hardware capable of processing data and executing instructions. The processor may be configured to control and coordinate operations within a computing system or device, including but not limited to data input/output, arithmetic and logic operations, memory management, and communication with other components.

The optical signal controller 310 may control the frequency modulation (or chirping) of the signal generator 100 described above and may include a feedback circuit such as a phase-locked loop PLL.

The switching controller 320 may control switching of a focal plane array FPA of at least one axis of a transmitter of the transceiver 200. At this time, the switching control may be manipulation of an optical Micro-Electromechanical System (MEMS). Additionally, this control may include a heating (or heat) control for a thermo-optical element that manipulates a phase of a micro ring resonator, mach-zender interferometer (MZI), etc. Additionally, this control may be a control for electro-optical modulation according to carrier concentration control.

The processor 330 may analyze a frequency of an electrical signal obtained from the receiver of the transceiver 200 and convert it into distance and/or speed information of the target object OBJ by executing instructions retrieved from a memory. For example, an analog electrical signal may be binarized through an analog-to-digital converter (e.g., the ADC shown in FIG. 4), and then, converted into frequency domain information through Fast Fourier Transform in a digital operation unit. Frequency domain information in each pixel may be converted into a point cloud representing a depth or speed map and may be used for higher-level applications, such as autonomous driving through an analysis algorithm that includes image processing.

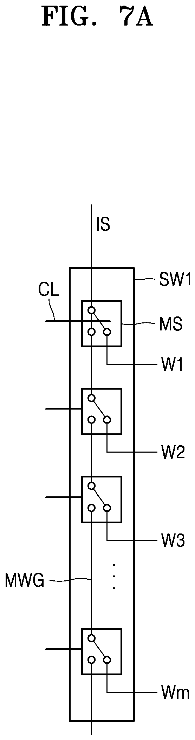

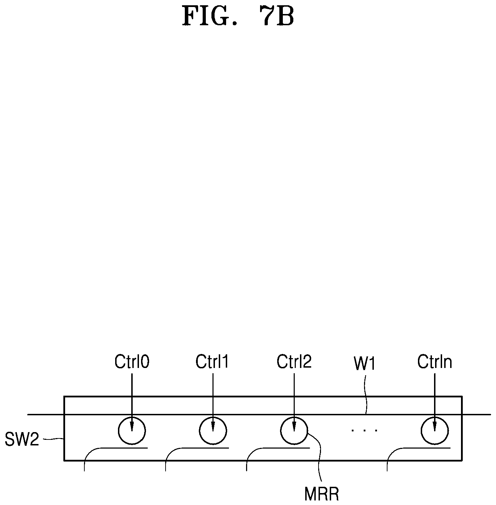

FIG. 6 is a diagram for explaining a driving method of a LiDAR system according to one or more embodiments. FIG. 7A is a diagram for explaining an operation of a MEMS switch. FIG. 7B is a diagram for explaining an operation of a micro ring resonator.

Referring to FIGS. 2, 4, and 6, the LIDAR system 1000 according to one or more embodiments may simultaneously output a plurality of multiplexed light L' as a transmission signal Tx in one-pixel PX included in the focal plane array FPA and may receive the received signal Rx reflected and returned by the target object OBJ. At this time, the transmission signal Tx may be a signal excluding the split local oscillator signal LO among the plurality of multiplexed lights L'.

Specifically, a plurality of lights L having different wavelengths generated by the light source unit 110 may be converted into multiplexed lights L' through the optical coupler 120. The multiplexed light L' may be provided to the focal plane array FPA through a main bus waveguide MWG.

In an on-state, the first optical switch SW1 may selectively transmit light from the main bus waveguide MWG to row waveguides W1 to Wm. The first optical switch SW1 may be implemented not only as an optical MEMS switch but also in other ways, such as wideband switching that may simultaneously turn on/off a wide frequency range from $\lambda 1$ to $\lambda n$. Therefore, a MZI switch may also be used.

Referring to FIG. 7A, the first optical switch SW1 may be implemented as an array of a plurality of MEMS switches MS. Each MEMS switch MS, according to a control signal provided through a corresponding control line CL, may steer an optical input signal IS from the main bus waveguide MWG, and accordingly, selectively provide the optical input signal IS to the plurality of row waveguides W1 to Wm.

Referring again to FIGS. 2, 4, and 6, the second optical switch SW2, in the on-state, may selectively transmit light from the row waveguides W1 to Wm selected by the first optical switch SW1 to pixels PX. The second optical switch SW2 is shown as a micro ring resonator, but is not limited thereto, and may be any switch that may sequentially or simultaneously turn on/off a plurality of wavelengths $\lambda 1$ to $\lambda n$ depending on the driving method. If the second optical switch SW1 is in the on-state, light may be emitted into a free space through the optical antenna 220.

Referring to FIG. 7B, the second optical switch SW2 may be implemented as an array of micro-ring resonators MRR. Each micro-ring resonator MRR may pick up an optical signal from a row waveguide (e.g. W1 to Wm) if a resonant frequency of the device is aligned with a laser wavelength. According to one implementation, electrical control signals (e.g., Ctrl0, Ctrl1, through Ctrln) set a resonance of each micro-ring resonator MRR in the array, and accordingly, may be used to select a pixel PX that receives the optical signal.

Referring again to FIGS. 2, 4, and 6, the transceiver 200 (or focal plane array FPA) may further include the optical amplifier 250 to compensate for optical attenuation and loss. The optical amplifier 250 may be disposed between the first optical switch SW1 and the second optical switch SW2 on the row waveguides W1 to Wm. Also, the optical amplifier 250 may be disposed between the second optical switch SW2 and the optical antenna 220 within the pixel PX. For example, the optical amplifier 250 may be a semiconductor optical amplifier SOA, which amplifies the optical signal so that the intensity of the light generated by the light source unit 110 is maintained in the optical antenna 220. Alternatively or additionally, the optical amplifier 250 may increase a signal-to-noise ratio SNR.

If a specific pixel PX is activated through the first optical switch SW1 and the second optical switch SW2, light transmitted through the waveguide may be emitted into a free space through the optical antenna 220. The optical antenna 220 may be implemented as a grating coupler. Light of different wavelengths $\lambda 1$ to $\lambda n$ may have different exit angles by the grating coupler and/or an optical element OP (refer to FIG. 2).

Light reflected and collected by the target object OBJ may be transmitted to a waveguide through the optical antenna 220. A portion of the light (or transmission signal Tx) transmitted to the optical antenna 220 may be mixed with the received signal Rx through the second optical coupler 230 and transmit a beating optical signal to the photoelectric converter 240. The photoelectric converter 240 may convert beating frequency information into an electrical signal. The photoelectric converter 240 may be implemented with the balanced photodiode 241 and the transimpedance amplifier TIA. However, the embodiment is not limited thereto, and the photoelectric converter 240 may be appropriately implemented using, for example, an avalanche photodiode, a single-photon avalanche diode, etc. The photoelectric converter 240 may further include a low-pass filter or a band-pass filter to filter out high-frequency components from the mixed signal and retain only meaningful beating frequencies.

If light of various wavelengths is simultaneously emitted and incident from and to one-pixel PX, because information of each wavelength is needed to be separately processed in the electric circuit 300 (e.g., the electric circuit 300 in FIG. 2 or the processor 330 in FIG. 5), the pixel PX may include a demultiplexer 260 for wavelengths in the waveguide in front of the second optical coupler 230. For example, the demultiplexer 260 may be implemented with an optical band pass filter, micro ring resonator, etc. FIG. 6 shows that the demultiplexer 260 is disposed in the waveguide between the optical antenna 220 and the second optical coupler 230, but embodiments of the present disclosure are not limited thereto. For example, the demultiplexer 260 may be disposed in the waveguide between the first optical coupler 210 and the second optical coupler 230.

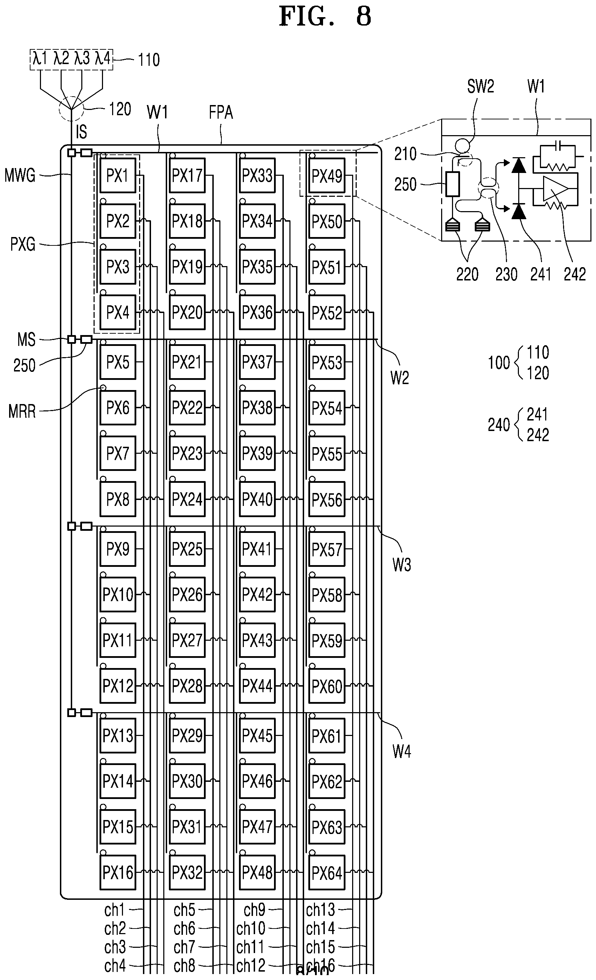

FIG. 8 is a diagram for explaining a driving method of a LiDAR system 1000 according to one or more embodiments. Here, for convenience of explanation, FIG. 8 illustrates a focal plane array FPA that receives four wavelengths different from each other and includes pixels arranged in a 16×4 matrix, but is not limited thereto.

The LiDAR system 1000 shown in FIG. 8 is different from the LiDAR system 1000 shown in FIG. 6 in that the LiDAR system 1000 of FIG. 8 emits a plurality of lights multiplexed in units of pixel groups PXG including a preset number of pixels (e.g., PX1, PX2, PX3, PX4), and the pixels do not include a demultiplexer, while the LiDAR system 1000 of FIG. 6 emits a plurality of lights from one pixel PX and a demultiplexer 260 is included in the pixel PX. The rest of the configuration is substantially the same.

Referring to FIGS. 2, 4, 7A, 7B, and 8, the LIDAR system 1000 according to one or more embodiments may include a signal generator 100 configured to generate a plurality of multiplexed lights, a transceiver 200 including a transmitter configured to simultaneously emit a plurality of multiplexed lights as a transmission signal in units of pixel groups PXG including at least two pixels (e.g., PX1, PX2, PX3, and PX4) and a receiver configured to mix the transmission signal and the received signal that is incident when the transmission signal is reflected from the target object and convert it into an electrical signal, and a electric circuit 300 connected to the signal generator 100 and the transceiver 200 and controlling operations thereof.

Each of the pixel groups PXG may include a preset number of pixels (e.g., PX1, PX2, PX3, and PX4), and the preset number of pixels (e.g., PX1, PX2, PX3, and PX4) are connected in parallel to each other. For example, in the focal plane array FPA, pixels PX1 to PX64 are arranged in a 16X4 matrix, each of the pixel groups PXG includes four pixels (e.g., PX1, PX2, PX3, and PX4) connected in parallel in a column direction, each among the pixels (e.g., PX1 to PX16) included in each of the pixel groups PXG arranged in the column direction, pixels (e.g., PX1, PX5, PX 9, and PX13) corresponding to the same order may be connected to the same output channel terminal (for example, ch1).

The electric circuit 300 according to one or embodiments may repeatedly operate the transceiver 200 in one cycle using stages (64 stages) as the same number as the number of pixels (PX1 to PX64) included in the focal plane array FPA.

A distance and/or speed of a target object may be calculated based on values of electrical signal equal to a multiplied number (e.g., 256) obtained by multiplying the number of pixels (e.g., 64) included in the focal plane array FPA by the number (e.g. 4) of pixels (e.g., PX1, PX2, PX3, and PX4) included in a pixel group PXG. As a result, high-resolution scanning may be implemented by simultaneously measuring a larger number of spatial points (e.g., 256) than the number of pixels (e.g., 64) included in the focal plane array FPA.

Specifically, light with different wavelengths $\lambda 1, \lambda 2, \lambda 3,$ and $\lambda 4$ may be sequentially output and incident on each of the pixels (e.g., PX1, PX2, PX3, and PX4) included in the pixel group PXG.

At this time, each pixel PX1, PX2, PX3, and PX4 may be activated simultaneously within the condition that crosstalk in each pixel is limited. To limit crosstalk, pixels PX1, PX2, PX3, and PX4 that are activated simultaneously may use light of different wavelengths. For example, the micro ring resonator MRR may be adjusted to selectively transmit only a specific wavelength among the plurality of wavelengths $\lambda 1$ to $\lambda 4$ to the optical antenna 220. In this way, if the wavelength of light used in each pixel is limited to a specific wavelength, even if light of various wavelengths is collected as a received signal Rx, because only beating with a wavelength component sufficiently close to the selected wavelength in the transmission signal Tx may pass through the low-pass filter or band-pass filter after the transimpedance amplifier 242, the demultiplexer 260 may be omitted, unlike the LIDAR system 1000 shown in FIG. 6.

For example, during four stages, the first pixel PX1 may emit light in the order of the first wavelength $\lambda 1$, the second wavelength $\lambda 2$, the third wavelength $\lambda 3$, and the fourth wavelength $\lambda 4$, the second pixel PX2 may emit light in the order of the second wavelength $\lambda 2$, the third wavelength $\lambda 3$, the fourth wavelength $\lambda 4$, and the first wavelength $\lambda 1$, the third pixel PX3 may emit light in the order of the third wavelength $\lambda 3$, the fourth wavelength $\lambda 4$, the first wavelength $\lambda 1$, and the second wavelength $\lambda 2$, and the fourth pixel PX4 may emit light emit light in the order of the fourth wavelength $\lambda 4$, the first wavelength $\lambda 1$, and the second wavelength $\lambda 2$, and the fourth wavelength $\lambda 3$. Accordingly, in the first stage, the first pixel PX1 may emit light of the first wavelength $\lambda 1$, the second pixel PX2 may emits light of the second wavelength $\lambda 2$, the third pixel PX3 may emit light of the third wavelength $\lambda 3$, and the fourth pixel PX4 may emit light of a fourth wavelength $\lambda 4$. That is, each of the pixels PX1, PX2, PX3, and PX4 included in the same pixel group PXG at the same time point (or stage) may simultaneously emit light of different wavelengths.

As described above, in FIG. 8, for the driving method of simultaneously driving a plurality of pixels (e.g., PX1, PX2, PX3, and PX4), an example of a two-dimensional focal plane array FPA having 4 wavelengths ($\lambda 1, \lambda 2, \lambda 3,$ and $\lambda 4$) and 16 x4 pixels PX1 to PX64 will be described. However, the embodiment is not limited thereto, and the specific implementation of the method for grouping and driving pixels may vary.

Pixels are grouped in groups of four in each column direction (e.g., PX1 to PX4, PX5 to PX8, etc.) and may receive the same power input. Accordingly, the plurality of pixels (e.g., PX1 to PX4) may be electrically activated. For example, if the pixels connected to the first row waveguide W1 are in an on-state, 16 pixels may be activated simultaneously. However, only one column may be optically selected and activated in each stage, and unselected columns may not provide meaningful photoelectric conversion signals even if the unselected columns are electrically activated. For example, if the pixels connected to the first row waveguide W1 are in an on-state and the first column is optically activated, each of the first channel ch1 to the fourth channel ch4 may provide information of the first pixel PX1 to the fourth pixel PX4 to the electric circuit 300. Therefore, parallel information-transmission of four channels at the same time is possible.

Table 1 below shows the row waveguides W1 to W4 activated according to the timing from t1 to t64 and wavelength information reflected in each channel through which information is transmitted.

[Table 1]

|  | t1 | t2 | t3 | t4 | t5 | t6 | t7 | t8 | t9 | t10 | t11 | t12 | t13 | t14 | t15 | t16 |
|---|---|---|---|---|---|---|---|---|---|---|---|---|---|---|---|---|
|  | W1 ON | | | | W2 ON | | | | W3 ON | | | | W4 ON | | | |
| ch1 | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ |
| ch2 | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ |
| ch3 | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ |
| ch4 | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ |
|  | t17 | t18 | t19 | t20 | t21 | t22 | t23 | t24 | t25 | t26 | t27 | t28 | t29 | t30 | t31 | t32 |
|  | W1 ON | | | | W2 ON | | | | W3 ON | | | | W4 ON | | | |
| ch5 | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ |
| ch6 | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ |
| ch7 | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ |
| ch8 | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ |
|  | t33 | t34 | t35 | t36 | t37 | t38 | t39 | t40 | t41 | t42 | t43 | t44 | t45 | t46 | t47 | t48 |
|  | W1 ON | | | | W2 ON | | | | W3 ON | | | | W4 ON | | | |
| ch9 | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ |
| ch10 | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ |
| ch11 | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ |
| ch12 | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ |
|  | t49 | t50 | t51 | t52 | t53 | t54 | t55 | t56 | t57 | t58 | t59 | t60 | t61 | t62 | t63 | t64 |
|  | W1 ON | | | | W2 ON | | | | W3 ON | | | | W4 ON | | | |
| ch13 | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ |
| ch14 | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ |
| ch15 | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ |
| ch16 | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ | $\lambda4$ | $\lambda1$ | $\lambda2$ | $\lambda3$ |

For example, a pixel group PXG connected to the first row waveguide W1 may maintain an on-state from the first stage t1 to the fourth stage t4.

In the first stage t1, the first pixel PX1 may provide a received signal corresponding to a transmission signal with a wavelength of $\lambda1$ to the first channel terminal ch1, the second pixel PX2 may provide a received signal corresponding to a transmission signal with a wavelength of $\lambda2$ to the second channel terminal ch2, the third pixel PX3 may provide a received signal corresponding to a transmission signal with a wavelength of $\lambda3$ to the third channel terminal ch3, and the fourth pixel PX4 may provide a received signal corresponding to a transmission signal with a wavelength of $\lambda4$ to the fourth channel terminal ch4.

In the second stage t2, the first pixel PX1 may provide a received signal corresponding to a transmission signal with a wavelength of $\lambda2$ to the first channel terminal ch1, the second pixel PX2 may provide a received signal corresponding to a transmission signal with a wavelength of λ3 to the second channel terminal ch2, and the third pixel PX3 may provide a received signal corresponding to a transmission signal with a wavelength of λ4 to the third channel terminal ch3, and the fourth pixel PX4 may provide a received signal corresponding to a transmission signal with a wavelength of λ1 to the fourth channel terminal ch4.

In the third stage t3, the first pixel PX1 may provide a received signal corresponding to a transmission signal with a wavelength of λ3 to the first channel terminal ch1, the second pixel PX2 may provide a received signal corresponding to a transmission signal with a wavelength of λ4 to the second channel terminal ch2, the third pixel PX3 may provide a received signal corresponding to the transmission signal with a wavelength of λ1 to the third channel terminal ch3, and the fourth pixel PX4 may provide a received signal corresponding to a transmission signal with a wavelength of λ2 to the fourth channel terminal ch4.

In the fourth stage t4, the first pixel PX1 may provide a received signal corresponding to a transmission signal with a wavelength of λ4 to the first channel terminal ch1, the second pixel PX2 may provide a received signal corresponding to a transmission signal with a wavelength of λ1 to the second channel terminal ch2, the third pixel PX3 may provide a received signal corresponding to a transmission signal with a wavelength of λ2 to the third channel terminal ch3, and the fourth pixel PX4 may provide a received signal corresponding to a transmission signal with a wavelength of λ3 to the fourth channel terminal ch4.

In this way, after each of the pixels PX1 to PX4 sweeps all of the wavelength λ1 to wavelength λ4 from the first stage t1 to the fourth stage t4, from a fifth stage t5 to an eighth stage t8, the pixel group PXG connected to the second row waveguide W2 may maintain in an on-state. The remaining stages t9 to t64 may also be driven similarly to the method described above. For example, when the second column of pixels PX17-PX32 are optically activated at t17 to t32, wavelength information may be reflected in channels ch5 to ch8. When the third column of pixels PX33-PX48 are optically activated at t33 to t48, wavelength information may be reflected in channels ch9 to ch12. When the fourth column of pixels PX49-PX64 are optically activated at t49 to t64, wavelength information may be reflected in channels ch13 to ch16. In the electric circuit 300, a logic circuit for determining that from which channel information will be retrieved may be implemented for each stage.

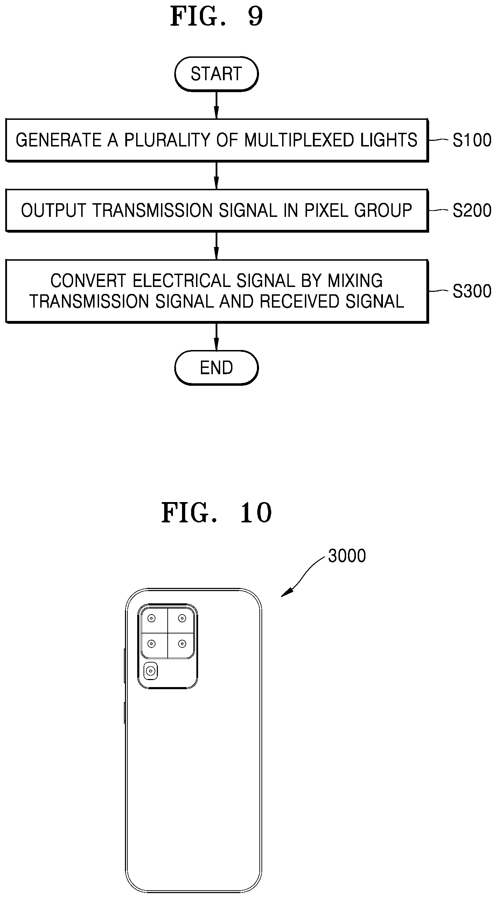

FIG. 9 is a flowchart for explaining a method of operating the LiDAR system 1000 according to one or more embodiments.

Referring to FIGS. 1 to 9, a method of operating the LIDAR system 1000 according to one or more embodiments may include generating a plurality of multiplexed lights through the signal generator 100 (operation S100), simultaneously emitting a plurality of multiplexed lights as a transmission signal Tx in units of pixel groups PXG including at least two pixels PX through the transceiver 200 (operation S200), and mixing the transmission signal Tx and the received signal Rx that is incident when the transmission signal Tx is reflected from the target object through the transceiver 200 and converting the mixed signal into an electrical signal (operation S300).

The transceiver 200 may include a focal plane array FPA, the focal plane array FPA is arranged in a 16 x 4 matrix, each of the pixel groups PXG may include four pixels PX connected in parallel in the column direction, and among the pixels PX included in each of the pixel groups PXG arranged in the column direction, pixels PX corresponding to the same order may be connected to the same output channel terminal.

The operating method of the LIDAR system 1000 may further include repeatedly operating the transceiver 200 in one cycle with the same number of stages as the number of pixels PX included in the focal plane array FPA, through the electric circuit 300, and calculating the distance and/or speed of a target object, based on values of electrical signal equal to the number of pixels PX included in the focal plane array FPA multiplied by the number of pixels PX included in the pixel group PXG during one cycle, through the electric circuit 300.

Among the pixel groups PXG, the first pixel group may include a first pixel PX1, a second pixel PX2, a third pixel PX3, and a fourth pixel PX4, and the first pixel PX1, the second pixel PX2, the third pixel PX3, and the fourth pixel PX4 may be turned on state at the same time.

For example, from the first stage t1 to the fourth stage t4, the pixel group PXG connected to the first row waveguide W1 may maintain an on-state.

In the first stage t1, the first pixel PX1 may provide a received signal corresponding to a transmission signal with a wavelength of λ1 to the first channel terminal ch1, and the second pixel PX2 may provide a received signal corresponding to a transmission signal with a wavelength of λ2 to the second channel terminal ch2, the third pixel PX3 may provide a received signal corresponding to a transmission signal with a wavelength of λ3 to the third channel terminal ch3, and the fourth pixel PX4 may provide a received signal corresponding to a transmission signal with a wavelength of λ4 to the fourth channel terminal ch4.

In the second stage t2, the first pixel PX1 may provide a received signal corresponding to a transmission signal with a wavelength of λ2 to the first channel terminal ch1, the second pixel PX2 may provide a received signal corresponding to a transmission signal with a wavelength of λ3 to the second channel terminal ch2, the third pixel PX3 may provide a received signal corresponding to a transmission signal with a wavelength of λ4 to the third channel terminal ch3, and the fourth pixel PX4 may provide a received signal corresponding to a transmission signal with a wavelength of λ1 to the fourth channel terminal ch4.

In the third stage t3, the first pixel PX1 may provide a received signal corresponding to a transmission signal with a wavelength of λ3 to the first channel terminal ch1, the second pixel PX2 may provide a received signal corresponding to a transmission signal with a wavelength of λ4 to the second channel terminal ch2, the third pixel PX3 may provide a received signal corresponding to a transmission signal with a wavelength of λ1 to the third channel terminal ch3, and the fourth pixel PX4 may provide a received signal corresponding to a transmission signal with a wavelength of λ2 to the fourth channel terminal ch4.

In the fourth stage t4, the first pixel PX1 may provide a received signal corresponding to a transmission signal with a wavelength of λ4 to the first channel terminal ch1, the second pixel PX2 may provide a received signal corresponding to a transmission signal with a wavelength of λ1 to the second channel terminal ch2, the third pixel PX3 may provide a received signal corresponding to a transmission signal with a wavelength of λ2 to the third channel terminal ch3, and the fourth pixel PX4 may provide a received signal corresponding to a transmission signal with a wavelength of λ3 to the fourth channel terminal ch4.

FIG.10 is a perspective view showing an example electronic device 3000 to which the LiDAR system according to one or more embodiments is applied.

In FIG. 10, the electronic device 3000 is shown in the form of a mobile phone or smart phone, but the implementation of the electronic device 3000 is not limited thereto. For example, the LiDAR system may be applied to tablets or smart tablets, laptop computers, televisions, or smart televisions.

Also, the LiDAR system according to one or more embodiments may be applied to autonomous driving devices.

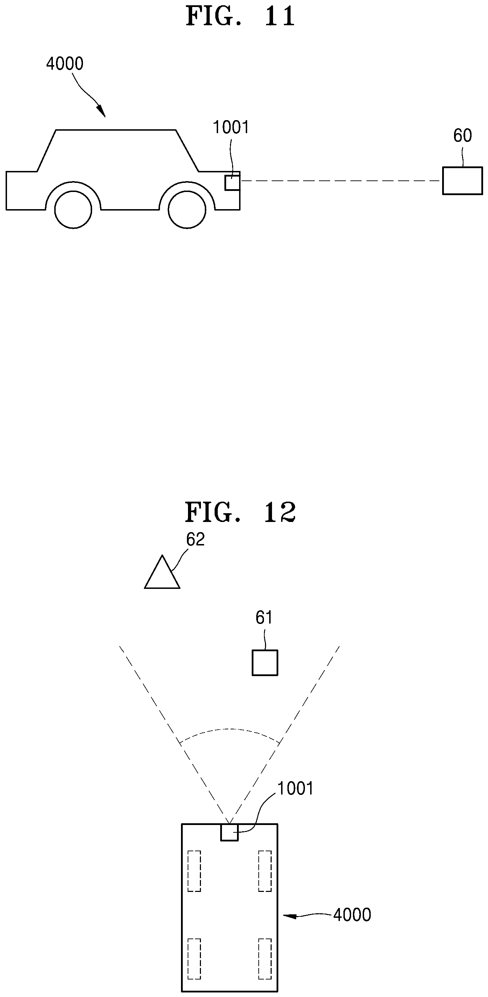

FIGS. 11 and 12 are conceptual diagrams showing a case when a LiDAR system 1001 according to one or more embodiments is applied to a vehicle 4000, and are a side view and a top view, respectively.

Referring to FIG. 11, the LIDAR system 1001 may be applied to the vehicle 4000, and information about an object 60 may be obtained using the LiDAR system 1001. The LiDAR system 1001 may be the LiDAR system 1000 described with reference to FIGS. 2 to 8. The LIDAR system 1001 may use a time-of-flight (TOF) method to obtain information (e.g., speed, distance, position, etc.) about the object 60. The vehicle 4000 may be a car with an autonomous driving capability. As described with reference to FIG. 11, the LiDAR system 1001 may split a target region of a target field of view into a plurality of sub-regions and irradiate a set of beams split one by one into the plurality of sub-regions at predetermined time intervals. If there is an object 60 in the target region and light reflected from the object 60 is detected, a digital scan of the target region may begin and information on the object 60 may be analyzed. Using the LiDAR system 1001, it is possible to detect an object or person, that is, the object 60 in a direction in which the vehicle 4000 travels, and a distance to the object 60 may be measured using information, such as the time difference between the transmission signal and the received signal. Also, as shown in FIG. 12, information about a close object 61 and a far object 62 within the target region may be obtained. The information about the objects 60, 61, and 62 may be processed and analyzed in real-time by onboard computational units (e.g., a processor, a central processing unit (CPU), or electronic control unit (ECU)) to determine optimal driving maneuvers or adjustments. Such maneuvers may include but are not limited to adjusting vehicle speed, changing lanes, maintaining safe distances from nearby objects, and avoiding potential collisions based on the dynamically updated information from the LIDAR system. The integration of LIDAR-derived object information allows for enhanced decision-making capabilities, thereby improving vehicle safety, efficiency, and overall driving experience in various environmental conditions and traffic scenarios.

FIGS. 11 and 12 illustrate a case that the LiDAR system 1001 is applied to a car, but the application is not limited thereto. The LiDAR system may be applied to flying objects such as drones, mobile devices, small walking devices (e.g., bicycles, motorcycles, strollers, boards, etc.), robots, human/animal assistive devices (e.g., walking sticks, helmets, accessories, clothing, watches, bags, etc.), Internet of Things (IoT) devices/systems, security devices/systems, etc.

According to the LiDAR system and the method of operating the same according to embodiments, a high-resolution scanning may be implemented by measuring a larger number of spatial points than the number of pixels by driving multiple wavelengths simultaneously or sequentially at one pixel included in a focal plane array.

The effects of the embodiments are not limited to the effects described above, and effects not mentioned may be clearly understood by those skilled in the art from the specification and the attached drawings.

The LiDAR system have been described with reference to the embodiment shown in the drawings. However, it will be understood by those of ordinary skill in the art that various changes in form and details may be made therein without departing from the scope of the disclosure. Therefore, the embodiments should be considered in descriptive sense only and not for purposes of limitation. The scope of the disclosure is defined not by the detailed description of the disclosure but by the appended claims, and all differences within the scope will be construed as being included in the disclosure.

The foregoing exemplary embodiments are merely exemplary and are not to be construed as limiting. The present teaching can be readily applied to other types of apparatuses. Also, the description of the exemplary embodiments is intended to be illustrative, and not to limit the scope of the claims, and many alternatives, modifications, and variations will be apparent to those skilled in the art.

**Claims**

1. A light detection and ranging (LiDAR) system comprising:

   a signal generator configured to generate a plurality of multiplexed lights;
   a transceiver comprising a transmitter and a receiver, wherein the transceiver is configured to simultaneously emit the plurality of multiplexed lights as a transmission signal, and the receiver is configured to mix the transmission signal and a received signal that is incident when the transmission signal is reflected from a target object to obtain a mixed signal and convert the mixed signal into an electrical signal; and
   an electric circuit connected to the signal generator and the transceiver, and configured to control the signal generator and the transceiver.

2. The LiDAR system of claim 1, wherein the signal generator comprises:

   at least one light source configured to generate a plurality of lights having different wavelengths;
   an optical coupler configured to simultaneously receive and multiplex the plurality of lights to obtain the plurality of multiplexed lights; and
   an optical modulator configured to modulate the plurality of multiplexed lights, and optionally wherein: the at least one light source comprises a plurality of laser sources; and
   the plurality of laser sources generate a plurality of lasers having different wavelengths.

3. The LiDAR system of any preceding claim, wherein the transceiver comprises a focal plane array in which pixel groups are arranged in a matrix form, and

   the focal plane array is configured to receive the transmission signal through a main bus waveguide, and optionally wherein a pixel included in the pixel groups comprises:
   a first optical coupler configured to split an input signal into the transmission signal and a local oscillator signal;
   an optical antenna configured to emit the transmission signal into a free space and receive the received signal from the free space;
   a second optical coupler configured to generate an output signal by mixing the local oscillator signal with the received signal; and
   a photoelectric converter configured to convert the output signal into the electrical signal.

4. The LiDAR system of claim 3, wherein the input signal is a frequency modulated continuous wave (FMCW) laser signal, and optionally wherein the photoelectric converter comprises:

   a balanced photodiode configured to convert an optical signal into the electrical signal; and
   a transimpedance amplifier configured to amplify strength of the electrical signal.

5. The LiDAR system of claim 4, wherein the electric circuit includes an analog-to-digital converter configured to binarize the electrical signal, and the photoelectric converter further comprises a low pass filter (LPF) or a band pass filter (BPF) to remove high-frequency components of the electrical signal.

6. The LiDAR system of claim 5, further comprising a first optical switch and a second optical switch, which are coupled to the focal plane array,

   wherein the first optical switch is configured to selectively provide the input signal to the focal plane array on a row-by-row basis, and
   the second optical switch is configured to selectively provide the input signal to the focal plane array in columns.

7. The LiDAR system of claim 6, wherein each of the pixel groups comprises a preset number of pixels, and the preset number of pixels are connected in parallel to each other.

8. The LiDAR system of claim 7, wherein the first optical switch and the second optical switch are one of a Micro-Electromechanical System (MEMS) switch array and a micro-ring resonator array, and optionally further comprising an optical amplifier located between the first optical switch and the optical antenna and configured to compensate for optical loss.

9. The LiDAR system of claim 8, wherein the focal plane array is arranged in a mXn matrix form, m and n denoting natural numbers greater than 2,

each of the pixel groups comprises four pixels connected in parallel in a column direction, and
among pixels included in each of the pixel groups arranged in the column direction, pixels corresponding to a same order are connected to a same output channel terminal.

10. The LiDAR system of claim 9, wherein the electric circuit is configured to repeatedly operate the transceiver in one cycle with a number of stages equal to the number of pixels included in the focal plane array, and calculate at least one of a distance and a speed of the target object, based on values of the electrical signal equal to the number of pixels included in the focal plane array multiplied by the number of pixels included in the pixel groups during the one cycle.

11. The LiDAR system of claim 9 or 10, wherein a first pixel group of the pixel groups comprises a first pixel, a second pixel, a third pixel, and a fourth pixel, and

the first pixel, the second pixel, the third pixel, and the fourth pixel are simultaneously in an on-state,
wherein, in a first stage, the first pixel is configured to provide a received signal corresponding to a transmission signal with a wavelength of $\lambda 1$ to a first channel terminal, the second pixel is configured to provide a received signal corresponding to a transmission signal with a wavelength of $\lambda 2$ to a second channel terminal, the third pixel is configured to provide a received signal corresponding to a transmission signal with a wavelength of $\lambda 3$ to a third channel terminal, and the fourth pixel is configured to provide a received signal corresponding to a transmission signal with a wavelength of $\lambda 4$ to a fourth channel terminal,
in a second stage, the first pixel is configured to provide a received signal corresponding to a transmission signal with the wavelength of $\lambda 2$ to the first channel terminal, the second pixel is configured to provide a received signal corresponding to a transmission signal with the wavelength of $\lambda 3$ to the second channel terminal, the third pixel is configured to provide a received signal corresponding to a transmission signal with the wavelength of $\lambda 4$ to the third channel terminal, and the fourth pixel is configured to provide a received signal corresponding to a transmission signal with the wavelength of $\lambda 1$ to the fourth channel terminal,
in a third stage, the first pixel is configured to provide a received signal corresponding to a transmission signal with the wavelength of $\lambda 3$ to the first channel terminal, the second pixel is configured to provide a received signal corresponding to a transmission signal with the wavelength of $\lambda 4$ to the second channel terminal, the third pixel is configured to provide a received signal corresponding to a transmission signal with the wavelength of $\lambda 1$ to the third channel terminal, and the fourth pixel is configured to provide a received signal corresponding to a transmission signal with the wavelength of $\lambda 2$ to the fourth channel terminal, and
in a fourth stage, the first pixel is configured to provide a received signal corresponding to a transmission signal with the wavelength of $\lambda 4$ to the first channel terminal, the second pixel is configured to provide a received signal corresponding to a transmission signal with the wavelength of $\lambda 1$ to the second channel terminal, the third pixel is configured to provide a received signal corresponding to a transmission signal with the wavelength of $\lambda 2$ to the third channel terminal, and the fourth pixel is configured to provide a received signal corresponding to a transmission signal with the wavelength of $\lambda 3$ to the fourth channel terminal.

12. A vehicle comprising:

a signal generator according to any preceding claim; and
a processor configured to determine a distance to the target object based on the plurality of reflected lights, and control a driving status of the vehicle based on electrical signal.

13. An operating method of a light detection and ranging (LiDAR) system, the operating method comprising:

generating a plurality of multiplexed lights;
simultaneously emitting the plurality of multiplexed lights as a transmission signal;
mixing a transmission signal and a received signal that is incident when the transmission signal is reflected from a target object to obtain a mixed signal; and
converting the mixed signal into an electrical signal.

14. The operating method of claim 13, wherein the operation method further comprises:

splitting an input signal into the transmission signal and a local oscillator signal;

emitting the transmission signal into a free space and/or receive the received signal from the free space;
generating an output signal by mixing the local oscillator signal and the received signal; and
converting the output signal into the electrical signal.

15. The operating method of claim 13 or 14, wherein the LiDAR system comprises a transceiver to emit the transmission signal, and the transceiver comprises a focal plane array, and
wherein the operating method further comprises:

repeatedly operating the transceiver in one cycle with a number of stages equal to a number of pixels included in the focal plane array, and
calculating at least one of a distance and speed of the target object, based on values of the electrical signal equal to the number of pixels included in the focal plane array multiplied by the number of pixels included in a pixel group during the one cycle.

# FIG. 1

# FIG. 2

# FIG. 3A

# FIG. 3B

# FIG. 3C

# FIG. 3D

# FIG. 4

PX

210 ── IS ──→ 250 Optical Amplifier ──→ 220 Optical Antenna ──→ Tx

Rx

LO ──────────→ 230

242 TIA ←──── ADC ←------- 242 TIA ──── 241 Balanced PD ←──── OS

240 { 241, 242 }

# FIG. 5

300

Optical Signal Controller ── 310

Switching Controller ── 320

Processor ── 330

# FIG. 6

# FIG. 7A

# FIG. 7B

# FIG. 8

# FIG. 9

START

GENERATE A PLURALITY OF MULTIPLEXED LIGHTS — S100

OUTPUT TRANSMISSION SIGNAL IN PIXEL GROUP — S200

CONVERT ELECTRICAL SIGNAL BY MIXING
TRANSMISSION SIGNAL AND RECEIVED SIGNAL — S300

END

# FIG. 10

3000

# FIG. 11

# FIG. 12

Europäisches
Patentamt

European
Patent Office

Office européen
des brevets

## EUROPEAN SEARCH REPORT

**Application Number**

EP 25 16 4643

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/121080 A1 (YAO XIAOTIAN STEVE [US]) 21 April 2022 (2022-04-21) | 1-10, 12-15 | INV.<br>G01S7/481 |
| A | * paragraphs [0029], [0039] - [0042], [0065] * | 11 | G01S7/4911<br>G01S7/4914 |
| X | US 2020/241119 A1 (ASGHARI MEHDI [US] ET AL) 30 July 2020 (2020-07-30)<br>* figures 4,7a,7b *<br>* paragraphs [0063] - [0066], [0071] - [0079] * | 1,12 | G01S7/4912<br>G01S17/34 |
| X | DE 10 2019 209933 A1 (ZEISS CARL AG [DE]) 7 January 2021 (2021-01-07)<br>* figure 1a *<br>* paragraphs [0040] - [0046] * | 1,12 | |

**TECHNICAL FIELDS SEARCHED (IPC)**

G01S

The present search report has been drawn up for all claims

| Place of search | Date of completion of the search | Examiner |
|---|---|---|
| Munich | 15 July 2025 | Unterberger, Michael |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 16 4643

This annex lists the patent family members relating to the patent documents cited in the above-mentioned European search report.
The members are as contained in the European Patent Office EDP file on
The European Patent Office is in no way liable for these particulars which are merely given for the purpose of information.

15-07-2025

| Patent document cited in search report | Publication date | Patent family member(s) | | Publication date |
|---|---|---|---|---|
| US 2022121080 A1 | 21-04-2022 | NONE | | |
| US 2020241119 A1 | 30-07-2020 | CN | 113574407 A | 29-10-2021 |
| | | EP | 3914928 A1 | 01-12-2021 |
| | | JP | 7489992 B2 | 24-05-2024 |
| | | JP | 2022517857 A | 10-03-2022 |
| | | US | 2020241119 A1 | 30-07-2020 |
| | | WO | 2020154707 A1 | 30-07-2020 |
| DE 102019209933 A1 | 07-01-2021 | NONE | | |

EPO FORM P0459

For more details about this annex : see Official Journal of the European Patent Office, No. 12/82